# FASCICULE DE BREVET EUROPEEN

(11) **EP 0 772 051 B1**
(45) Date de publication et mention de la délivrance du brevet: **09.07.2003**
(21) Numéro de dépôt: 96402320.4
(22) Date de dépôt: 31.10.1996
(51) Int. Cl.: G01R 15/24

(54) **Transformateur de mesure non-conventionnel**
Nichtherkömmlicher Messwandler
Non-conventional measuring transformer

(30) Priorité: 06.11.1995 FR 9513083
(43) Date de publication de la demande: 07.05.1997
(73) Titulaire: GEC ALSTHOM T & D BALTEAU, 92120 Montrouge (FR)
(72) Inventeur: Chatrefou, Denis, 91860 Epinay sous Senart (FR); Mironneau, Jean-François, 91300 Massy (FR); Delbos, Philippe, 91640 Brils sous Forges (FR)
(74) Mandataire: Gosse, Michel

(56) Documents cités:
- EP-A- 0 448 342
- EP-A- 0 517 147
- DE-A- 4 100 054
- FR-A- 2 418 468

## Description

L'invention concerne les transformateurs de mesure qui servent aux fonctions de protection et de mesure dans un réseau électrique haute tension (100 à 800 KV par exemple).

Les transformateurs de mesure non - conventionnels exploitent des capteurs optiques. Chaque capteur optique est un système combiné incluant une sonde optique (par exemple du type anneau de verre) et une carte de circuits optoélectroniques reliée à la sonde par fibres optiques. La sonde optique est destinée à être placée au voisinage de la grandeur électrique à mesurer (c'est-à-dire près du conducteur primaire haute tension). Elle comporte un milieu sensible spécial qui présente une légère modification de structure lorsqu'il reçoit un champ magnétique ou électrique. Un faisceau lumineux, généré par la carte de circuits optoélectroniques, est injecté dans la sonde et le faisceau lumineux réfléchi sert à mesurer la grandeur électrique suivant des principes bien connus du type effet Faraday pour mesurer une intensité d'une ligne électrique ou effet Pockels pour mesurer la tension de la ligne électrique. La carte de circuits optoélectroniques restitue en sortie, une information numérique représentative de la grandeur électrique mesurée, après un traitement du signal optique récupéré de la sonde. Par la suite, on désigne par capteur optique d'intensité, un capteur optique du type à effet Faraday pour mesurer l'intensité d'un courant d'une ligne électrique et par capteur optique de tension, un capteur optique du type à effet Pockels pour mesurer la tension du courant de la ligne électrique.

On connaît ainsi des capteurs optiques d'intensité pour mesurer des intensités de courants électriques avec une dynamique de mesure adaptée à une fonction protection (modèle "BK7" de la société "SCHOTT") ou avec une dynamique beaucoup plus faible mais avec une précision de mesure adaptée à une fonction mesure (modèle "SF57" de la société "SCHOTT"). Par ailleurs, du document de brevet FR-9301991, on connait un capteur optique d'intensité à grande dynamique de mesure adapté à une fonction protection et ayant un anneau de verre commun à deux voies de sortie indépendantes (c'est-à-dire deux cartes de circuits optoélectroniques).

En très haute tension, l'obtention d'une série d'avantages non rappelés ici, font penser que de tels transformateurs non-conventionnels à capteurs optiques sont amenés à remplacer les transformateurs de mesure dits conventionnels à base de tores en matériau ferromagnétique sur lesquels sont enroulés des fils de cuivre (servant de secondaire) devant être directement connectés aux équipements basse tension de protection et/ou de mesure.

L'exploitation de tels transformateurs de mesure non-conventionnels soulève toutefois des problèmes de fiabilité et de disponibilité en raison de la présence des circuits optoélectroniques généralement complexes et moins fiables que de simples fils de cuivre.

En particulier, les cartes de circuits optoélectroniques des capteurs optiques sont généralement garanties pour une panne tous les cinq ans à comparer à une panne tous les trente ans comme spécifié dans le cahier des charges des transformateurs de mesure conventionnels.

Pour palier cet inconvénient, il est donc nécessaire de prévoir une certaine redondance des capteurs optiques, c'est à dire de prévoir dans un transformateur de mesure non-conventionnel, une pluralité de capteurs optiques pour mesurer la même grandeur électrique. Les techniques de redondance avec vote majoritaire sont bien connues. Ainsi, il serait envisageable de prévoir dans un transformateur de mesure non conventionnel, pour chaque phase de la ligne électrique et pour chaque grandeur électrique (courant ou tension) à mesurer, trois capteurs optiques ayant des sorties respectives connectées à un moyen de traitement de données fonctionnant pour restituer en sortie, l'information produite par une voie de sortie d'un des trois capteurs suivant le principe du vote majoritaire. Toutefois, cette configuration s'avère en pratique très coûteuse. En effet, elle requière, pour chaque grandeur électrique à mesurer et pour chaque phase, trois capteurs optiques pour la fonction protection et trois capteurs optiques pour la fonction mesure, soit donc six capteurs optiques.

Le but de l'invention est de proposer un transformateur de mesure non - conventionnel ayant une architecture redondante avec plusieurs capteurs optiques et des moyens de traitement de données fonctionnant pour restituer en sortie l'information produite par une voie de sortie d'un des capteurs optiques suivant le principe du vote majoritaire, qui d'une part, satisfait aux contraintes de fiabilité et disponibilité des informations de mesure pour assurer des fonctions de protection et de mesure et qui, d'autre part, présente un coût de revient acceptable.

A cet effet, l'invention a pour objet un transformateur de mesure non -conventionnel pour un équipement de protection et/ou de mesure d'un réseau électrique triphasé, caractérisé en ce qu'il fournit une information numérique représentative d'une tension mesurée pour une certaine phase d'une ligne électrique dans le réseau électrique, cette information numérique de tension étant destinée à une fonction protection ou à une fonction mesure dudit équipement, en ce qu'il comprend un premier et un second capteur optique de tension et en ce que les sorties desdits premier et second capteurs optiques de tension et une combinaison des sorties respectives de deux autres capteurs optiques de tension prévus respectivement pour les deux autres phases de la ligne sont traitées par des moyens de traitement numérique pour valider ladite information numérique de tension par un vote majoritaire.

Dans le cas de la tension, la dynamique de mesure nécessaire est relativement limitée et il est possible de produire ladite information numérique de tension avec les mêmes capteurs optiques de tension pour la fonction protection comme pour la-fonction mesure. Par ailleurs, pour un réseau électrique triphasé, hors défaut, la somme des trois tensions mesurées des trois phases de la ligne électrique est nulle et par conséquent, il est possible d'obtenir une mesure de la tension pour une phase en faisant la somme des tensions mesurées pour les deux autres phases de la ligne électrique. Les moyens de traitement de données peuvent alors être agencés pour traiter la combinaison des sorties des deux autres capteurs optiques de tension afin de valider la sortie de l'un ou l'autre desdits premier ou second capteurs optiques de tension dans le vote majoritaire. Ainsi, un capteur optique de tension est économisé pour chaque phase de la ligne électrique par rapport à une solution à redondance massive telle qu'exposée ci-dessus.

L'invention a aussi pour objet un transformateur de mesure non -conventionnel pour un équipement de protection et/ou de mesure d'un réseau électrique triphasé, caractérisé en ce qu'il fournit une information numérique représentative dune intensité mesurée pour une certaine phase d'une ligne électrique dans le réseau électrique, cette information numérique d'intensité étant destinée à une fonction protection ou à une fonction mesure dudit équipement, en ce qu'il comprend un premier et un second capteur optique d'intensité ayant chacun une dynamique adaptée à une fonction protection dudit équipement, un troisième capteur optique d'intensité ayant une précision adaptée à une fonction mesure dudit équipement et en ce que les sorties respectives desdits premier, second et troisième capteurs optiques d'intensité sont traitées par des moyens de traitement numérique pour valider ladite information numérique d'intensité par un vote majoritaire.

Selon cet agencement, les moyens de traitement numériques sont agencés pour ne pas transmettre la sortie du troisième capteur optique d'intensité quand l'information numérique d'intensité est destinée à une fonction de protection, car en cas de défaut du système électrique haute tension (court-circuit), un tel capteur optique ne possède pas la dynamique suffisante pour assurer une fonction de protection. La sortie de ce capteur optique est donc exploitée par les moyens de traitement pour valider la sortie de l'un ou l'autre desdits premier ou second capteurs optiques d'intensité qui est alors fournie à la fonction protection. Par contre, c'est la sortie du troisième capteur optique d'intensité qui sert normalement à produire l'information numérique d'intensité quand celle-ci est destinée à une fonction de mesure.

On comprend qu'ainsi, un transformateur de mesure non-conventionnel du type à tension seulement selon l'invention, requiert seulement deux capteurs optiques de tension, par phase de la ligne électrique, pour assurer des fonctions de protection et/ou de mesure de tension. Un transformateur de mesure non-conventionnel du type à intensité seulement selon l'invention, requiert trois capteurs optiques d'intensité, par phase de la ligne électrique, pour assurer à la fois une fonction de protection et une fonction de mesure d'intensité. Par ailleurs, les deux capteurs optiques d'intensité à grande dynamique de mesure peuvent avantageusement être prévus avec un anneau de verre commun à deux voies de sortie comme indiqué ci-dessus ce qui réduit encore le coût d'un tel transformateur.

L'invention s'étend encore à un combiné de mesure non-conventionnel présentant les caractéristiques indiquées ci-dessus.

D'autres caractéristiques et avantages ressortiront encore mieux de la description qui suit d'un exemple de réalisation de l'objet de l'invention.

La figure 1 montre l'aspect général d'un transformateur de mesure non-conventionnel pour une phase donnée d'une ligne électrique dans un réseau électrique haute tension triphasé.

La figure 2 montre schématique l'architecture redondante d'un combiné de mesure non conventionnel selon l'invention.

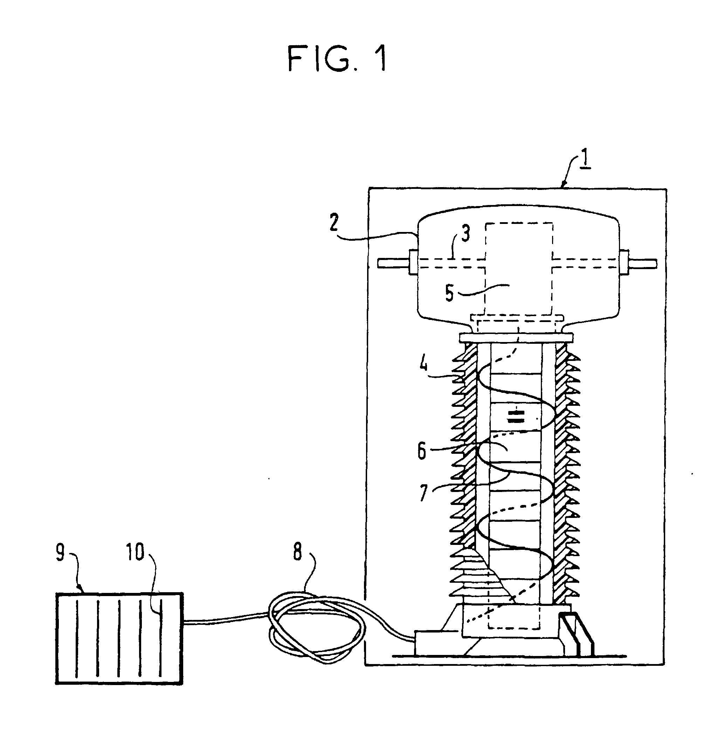

Figure 1, un transformateur de mesure non-5 conventionnel du type à tension seulement, à intensité seulement ou les deux à la fois (combiné), comporte une structure 1 (une structure par phase de la ligne électrique électrique triphasée) incluant une tête 2 dans laquelle sont logés les sondes des capteurs optiques. La tête 2 est traversée par une barre métallique 3 associée à une phase de la ligne électrique sur laquelle portent les mesures. La tête 2 est isolée du sol par un isolateur électrique constituant un support 4. Les sondes des capteurs optiques sont logées dans un boîtier 5 placé à l'intérieur de la tête 2 et spécialement conçu pour résister aux chocs thermiques ou mécaniques. Les cartes de circuits optoélectroniques 10 des capteurs optiques sont placées dans un rack 9 disposé à distance de la structure 1. Les sondes des capteurs optiques sont reliées par fibres optiques 7,8 aux cartes optoélectroniques 10. En outre, le support est conçu avec un diviseur capacitif 6 quand des capteurs optiques de tension sont mis en jeu.

Les cartes de circuits optoélectroniques 10 sont prévues pour gérer l'émission et la réception des signaux lumineux vers les sondes à travers les fibres optiques 7 et 8, et produire en sortie des informations numériques représentatives des grandeurs physiques à mesurer. Chaque carte optoélectronique 10 d'un capteur optique est conçue pour délivrer sur une voie de sortie, par exemple numérique du type RS232 ou parallèle à 16 bits, l'information numérique représentative d'une intensité ou d'une tension, cette information numérique servant à un ou plusieurs équipements de protection et/ou de mesure classiques en soi (non représentés).

Un transformateur de mesure non-conventionnel selon l'invention présente une architecture redondante pour satisfaire aux contraintes de fiabilité et de disponibilité requises. Plus particulièrement, il est prévu un certain nombre de capteurs optiques pour mesurer chaque grandeur électrique (intensité ou tension) de la ligne électrique triphasée dans un réseau haute tension. Les voies de sortie des cartes optoélectroniques des capteurs optiques fournissent donc en parallèle des informations numériques redondantes représentatives de la grandeur électrique mesurée.

Suivant l'invention, ces informations numériques sont reçues en parallèle par des moyens de traitement numérique aptes à réaliser un vote majoritaire du type 2/3. Toutefois, une redondance massive des capteurs optiques n'est pas utile et on verra par la suite comment tirer partie, d'une part, des spécificités de la haute tension triphasée et, d'autre part, des performances des capteurs optiques pour réduire le nombre de ces derniers dans un transformateur de mesure non conventionnel.

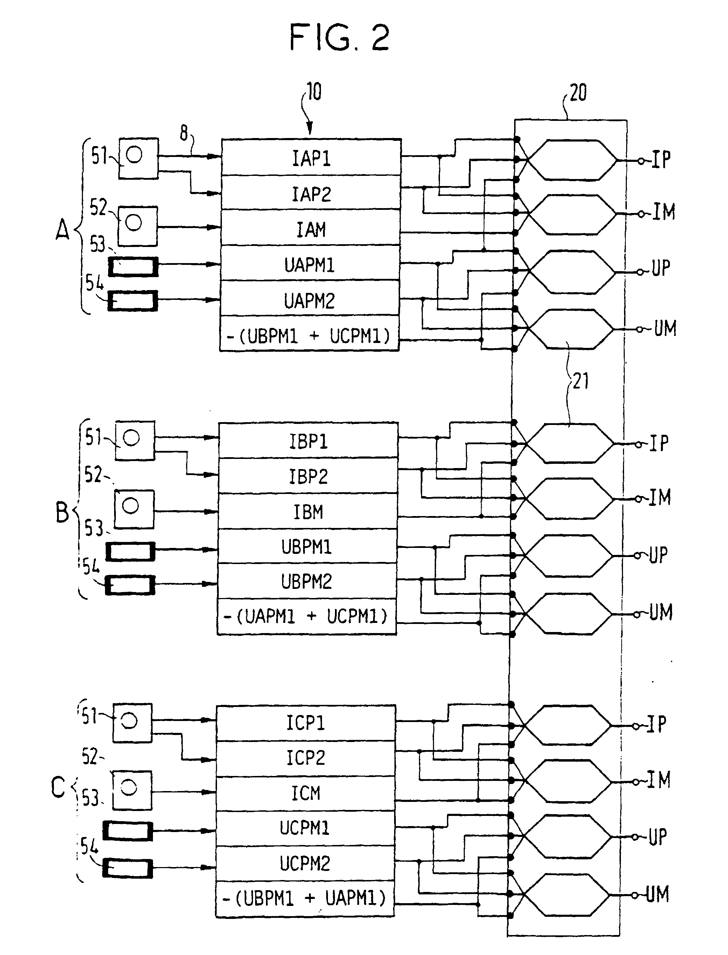

La figure 2 montre l'architecture redondante d'un transformateur de mesure non - conventionnel selon l'invention, ici un transformateur du type combiné apte à fournir, pour chaque phase d'un courant triphasé, des informations numériques IP et IM représentatives de l'intensité du courant et des informations numériques UP et UM représentatives de la tension de la ligne.

A noter que les informations IP et UP sont destinées plus particulièrement à une fonction protection tandis que les informations IM et UM sont destinées plus particulièrement à une fonction mesure ou comptage énergétique.

La structure du transformateur non-conventionnel selon l'invention est décrite ci-après pour une phase de la ligne Comme la phase A, sachant qu'elle est analogue pour les deux autres phases B et C.

Pour fournir l'information numérique IP (phase A) représentative d'une intensité, le transformateur comprend deux capteurs optiques d'intensité ayant de préférence une sonde commune 51 à deux cartes optoélectroniques dont les voies de sorties respectives sont désignées symboliquement par IAP1 et IAP2. Il s'agit ici de deux capteurs optiques d'intensité à grande dynamique de mesure adaptés pour une fonction protection. Il inclut encore un capteur optique d'intensité à grande précision (mais dont la dynamique de mesure est environ cinq fois inférieure à celle des deux capteurs précédents) ayant une sonde indiquée par 52 et une carte optoélectronique dont la voie de sortie est désignée symboliquement par IAM et qui est plus particulièrement adaptée à une fonction mesure. Les voies de sortie IAP1,IAP2 et IAM des capteurs optiques d'intensité sont traitées par des moyens de traitement numérique 20 qui fournissent en sortie l'information numérique IP sur la base d'un vote majoritaire un peu dégradé. Plus particulièrement, l'information numérique IP correspond à l'une des voies de sortie IAP1 ou IAP2 (qui possèdent la dynamique suffisante en cas de court-circuit), la voie IAM servant ici à valider le cas échéant l'une des deux voies IAP1 ou IAP2.

L'information numérique IM (pour la phase A) destinée à une fonction mesure, est produite à partir des mêmes voies de sortie IAP1,IAP2 et IAM. Toutefois, les moyens de traitement numériques 20 sont agencés pour privilégier la voie de sortie IAM (plus précise pour une fonction mesure). En d'autres termes, l'information numérique IM correspond à la voie de sortie IAM en l'absence de panne de cette voie, les voies de sortie IAP1 et IAP2 servant à valider la voie de sortie IAM. En cas de panne de la voie de sortie IAM, l'une des voies IAP1 ou IAP2 est avantageusement- utilisée pour fournir l'information IM en attendant le remplacement de la carte optoélectronique (IAP1 ou IAP2) défectueuse.

Pour fournir l'information numérique UP (phase A) représentative d'une tension, le transformateur comprend deux capteurs optiques de tension avec des sondes 53 et 54 et des cartes optoélectroniques dont les voies de sorties respectives sont désignées symboliquement par UAPM1 et UAPM2. Les voies de sortie UAPM1 et UAPM2 et une combinaison des voies de sortie UBPM1 et UCPM1 de deux autres capteurs optiques de tension prévus respectivement pour les deux autres phases (phase B, phase C) de la ligne sont traitées par les moyens de traitement numérique 20 pour dériver l'information numérique de tension UP par un vote majoritaire un peu dégradé. Plus particulièrement, l'information numérique UP correspond à l'une des voies de sortie UAPM1 ou UAPM2, la combinaison des voies de sorties (-(UBPM1+UCPM1)) servant uniquement à valider l'une des voies UAPM1 ou UAPM2 en raison du fait qu'elle est moins précise que les voies UAPM1 ou UAPM2.

L'information numérique UM (phase A) est dérivée de la même façon que l'information numérique UP et avec les mêmes capteurs. En d'autres termes, elle correspond à l'une des voies de sortie UAPM1,UAPM2, la combinaison de voies de sorties (-(UBPM1+UCPM1)) servant encore à valider Tune des ces deux voies de sortie UAPM1 ou UAPM2.

Ainsi, l'architecture d'un transformateur de mesure non-conventionnel selon l'invention, du type combiné, fait intervenir seulement cinq capteurs optiques par phase, deux de ces capteurs pouvant avoir une sonde commune, ce qui contribue à abaisser considérablement le prix de revient d'un tel transformateur de mesure tout en répondant aux contraintes de fiabilité et de disponibilité des mesures.

En pratique, la carte électronique de chaque capteur optique délivre sur une voie de sortie, des échantillons à une fréquence de 20 KHz de sorte que les moyens de traitement numérique 20 disposent d'un temps d'environ 50 microsecondes pour effectuer le vote majoritaire sur trois entrées. Ces moyens de traitement numérique 20 sont constitués de préférence d'une pluralité de microcontrôleurs 21, par exemple le circuit 80C166 de la société SIEMENS, chaque microcontrôleur 21 étant affecté à une sortie IM,IP,UM,UP pour une phase donnée du courant comme visible sur la figure 2.

A noter que la technique du vote majoritaire permet d'assurer la continuité de service des fonctions protection et/ou mesure en cas de panne de l'une des cartes optoélectroniques des capteurs optiques. Par ailleurs, chaque microcontrôleur est programmé pour exécuter trois programmes d'acquisition d'informations numériques sur trois voies d'entrée respectives et un programme de décision. Un niveau de priorité d'exécution est affecté à chaque programme, le programme de décision ayant le niveau de priorité le plus faible. Le niveau de priorité le plus élevé est affecté au programme d'acquisition correspondant à un des capteurs dont la voie de sortie sert normalement à fournir l'information numérique de mesure en sortie du microcontrôleur. Le rôle du programme de décision est donc de comparer les informations acquises par les programmes d'acquisition et de donner l'autorisation à ce programme d'acquisition de niveau de priorité le plus élevé, de transmettre l'information acquise vers un organe de sérialisation correspondant à la sortie du microcontrôleur. De cette façon, l'intervalle de temps entre les informations numériques (ou échantillons) sur les voies d'entrée du microcontrôleur est préservé sur la voie de sortie de celui-ci. En outre, la carte optoélectronique de chaque capteur optique est pourvue d'une logique de détection d'erreur de fonctionnement en communication constante avec le microcontrôleur auquel elle est reliée pour traiter les cas où le réseau électrique haute tension sous surveillance est en défaut (court-circuit) en même temps qu'un capteur optique est en panne.

Grâce aux fait qu'un transformateur de mesure non-conventionnel selon l'invention délivre des informations numériques, il peut être connecté à un équipement de protection et/ou de mesure par l'intermédiaire d'une liaison galvanique directe pour un raccordement de proximité ou par des fibres optiques pour un raccordement à grande distance avec des contraintes d'indépendance galvanique. Par ailleurs, les équipements de protection et/ou de mesure conventionnels sont des équipements basse tension dont les entrées reçoivent des signaux de puissance qui sont transformés, au niveau de secondaires, en signaux numériques. Dans ce cas, au lieu de prévoir une interface entre un transformateur de mesure non-conventionnel selon l'invention et de tels équipements basse tension pour reconstituer les signaux de puissance à partir des sorties numérique du transformateur, il sera plus avantageux de raccorder directement, au niveau secondaire des transformateurs des équipements basse tension de protection et/ou de mesure, les sorties d'un tel transformateur non-conventionnel.

## Revendications

1. Un transformateur de mesure non - conventionnel affecté à la mesure d'une tension pour un équipement de protection et/ou de mesure d'un réseau électrique triphasé, **caractérisé en ce qu'**il fournit une information numérique (UP,UM) représentative de la tension mesurée pour une certaine phase (A) d'une ligne électrique dans le réseau électrique, cette information numérique de tension étant destinée à une fonction protection ou à une fonction mesure dudit équipement, **en ce qu'**il comprend un premier et un second capteur optique de tension (53,54,10) et **en ce que** les sorties (UAPM1,UAPM2) desdits premier et second capteurs optiques de tension et une combinaison des sorties respectives (UBPM1,UCPM1) de deux autres capteurs optiques de tension prévus respectivement pour les deux autres phases (B, C) de la ligne sont traitées par des moyens de traitement numérique (20) pour valider ladite information numérique de tension par un vote majoritaire.

2. Un transformateur de mesure non - conventionnel affecté à la mesure de l'intensité d'un courant pour un équipement de protection et/ou de mesure d'un réseau électrique triphasé, **caractérisé en ce qu'**il fournit une information numérique (IP,IM) représentative de l'intensité mesurée pour une certaine phase (A) d'une ligne électrique dans le réseau électrique, cette information numérique d'intensité étant destinée à une fonction protection ou à une fonction mesure dudit équipement, **en ce qu'**il comprend un premier et un second capteur optique d'intensité (51,10) ayant chacun une dynamique de mesure adaptée à une fonction protection dudit équipement, un troisième capteur optique d'intensité (52,10) ayant une précision de mesure adaptée à une fonction mesure dudit équipement et **en ce que** les sorties respectives (IAP1,IAP2,IAM) desdits premier, second et troisième capteurs optiques d'intensité sont traitées par des moyens de traitement numérique (20) pour valider ladite information numérique d'intensité par un vote majoritaire.

3. Le transformateur selon la revendication 2, dans lequel lesdits premier et second capteurs optiques d'intensité sont conçus avec une sonde commune (51).

4. Un combiné de mesure non - conventionnel pour un équipement de protection et/ou de mesure d'un système électrique triphasé, comprenant un transformateur selon la revendication 1 et un transformateur selon l'une des revendications 2 ou 3.

## Patentansprüche

1. Nicht herkömmlicher Messtransformator, der für die Messung einer Spannung für ein Schutz- und/oder Messgerät eines Dreiphasen-Stromnetzes eingesetzt wird, **dadurch gekennzeichnet, dass** er digitale Informationen (UP, UM) liefert, die die gemessene Spannung für eine bestimmte Phase (A) einer elektrischen Leitung in dem Stromnetz repräsentieren, wobei diese digitalen Informationen bezüglich der Spannung für eine Schutz- oder Messfunktion des Geräts bestimmt sind, dass er einen ersten und einen zweiten optischen Spannungssensor (53, 54, 10) umfasst und dass die Ausgangssignale (UAPM1, UAPM2) des ersten und des zweiten optischen Spannungssensors sowie eine Kombination entsprechender Ausgangssignale (UBPM1, UCPM1) von zwei weiteren optischen Spannungssensoren, die für die beiden anderen Phasen (B, C) der Leitung vorgesehen sind, durch digitale Verarbeitungsmittel (20) verarbeitet werden, um die digitalen Informationen bezüglich der Spannung durch ein Mehrheitsvotum für gültig zu erklären.

2. Nicht herkömmlicher Messtransformator, der für die Messung der Stromintensität für ein Schutz- und/oder Messgerät eines Dreiphasen-Stromnetzes eingesetzt wird, **dadurch gekennzeichnet, dass** er digitale Informationen (IP, IM) liefert, die die gemessene Intensität für eine bestimmte Phase (A) einer elektrischen Leitung in dem Stromnetz repräsentieren, wobei diese digitalen Informationen bezüglich der Intensität für eine Schutz- oder Messfunktion des Geräts bestimmt sind, dass er einen ersten und einen zweiten optischen Intensitätssensor (51, 10), die jeweils eine an die Schutzfunktion des Geräts angepasste Messdynamik besitzen, sowie einen dritten optischen Intensitätssensor (52, 10), der eine an eine Messfunktion des Geräts angepasste Messgenauigkeit besitzt, umfasst und dass die jeweiligen Ausgangssignale (IAP1, IAP2, IAM) des ersten, des zweiten und des dritten optischen Intensitätssensors durch digitale Verarbeitungsmittel (20) verarbeitet werden, um die digitalen Intensitätsinformationen durch ein Mehrheitsvotum für gültig zu erklären.

3. Transformator nach Anspruch 2, bei dem der erste und der Zweite optische Intensitätssensor mit einem gemeinsamen Fühler (51) versehen sind.

4. Nicht herkömmliche Messkombination für ein Schutz- und/oder Messgerät eines elektrischen Dreiphasensystems, die einen Transformator nach Anspruch 1 und einen Transformator nach einem der Ansprüche 2 oder 3 umfasst.

## Claims

1. An unconventional measurement transformer for measuring a voltage for protection and/or measurement equipment of a three-phase electricity grid, the transformer being **characterized in that** it delivers digital information (UP, UM) representative of the measured voltage for a certain phase (A) of an electricity line in the electricity grid, said voltage digital information being intended for a protection function or a measurement function of said equipment, **in that** it comprises first and second optical voltage sensors (53, 54, 10), and **in that** the outputs (UAPM1, UAPM2) of said first and second optical voltage sensors and a combination of respective outputs (UBPM1, UCPM1) of two other optical voltage sensors provided respectively for the other two phases of the line (B, C) are processed by digital processing means (20) to validate said voltage digital information by a majority vote.

2. An unconventional measurement transformer for measuring a current for protection and/or measurement equipment of a three-phase electricity grid, the transformer being **characterized in that** it delivers digital information (IP, IM) representative of the measured current for a certain phase (A) of an electricity line in the electricity grid, said current digital information being intended for a protection function or a measurement function of said equipment, **in that** it comprises first and second optical current sensors (51, 10), each having a measurement dynamic range adapted to a protection function of said equipment, a third optical current sensor (52, 10) having measurement accuracy adapted to a measurement function of said equipment, and **in that** the outputs (IAP1, IAP2, IAM) of said first, second, and third optical current sensors are processed by digital processing means (20) to validate said current digital information by a majority vote.

3. The transformer of claim 2, in which said first and second optical current sensors are designed with a common probe (51).

4. An unconventional measurement combination unit for protection and/or measurement equipment of a three-phase electricity system, the unit comprising both a transformer according to claim 1 and a transformer according to claim 2 or 3.
